(19) **Europäisches Patentamt / European Patent Office / Office européen des brevets**

(11) **EP 3 653 019 B1**

(12) **FASCICULE DE BREVET EUROPEEN**

(45) Date de publication et mention de la délivrance du brevet:
**09.02.2022 Bulletin 2022/06**

(21) Numéro de dépôt: **18735337.0**

(22) Date de dépôt: **09.07.2018**

(51) Classification Internationale des Brevets (IPC):
**H05B 3/00** *(2006.01)* **G05F 3/26** *(2006.01)*
**G05F 3/30** *(2006.01)* **H03K 3/282** *(2006.01)*

(52) Classification Coopérative des Brevets (CPC):
**H05B 3/0019; G05F 3/265; G05F 3/30; H03K 3/2823**

(86) Numéro de dépôt international:
**PCT/EP2018/068516**

(87) Numéro de publication internationale:
**WO 2019/011845 (17.01.2019 Gazette 2019/03)**

(54) **DISPOSITIF DE REGENERATION DE COMPOSANTS ELECTRONIQUES EN ENVIRONNEMENT NUCLEAIRE**

VORRICHTUNG ZUR REGENERATION VON ELEKTRONISCHEN KOMPONENTEN IN EINER NUKLEAREN UMGEBUNG

DEVICE FOR REGENERATING ELECTRONIC COMPONENTS IN A NUCLEAR ENVIRONMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.07.2017 FR 1756630**

(43) Date de publication de la demande:
**20.05.2020 Bulletin 2020/21**

(73) Titulaire: **Commissariat à l'Énergie Atomique et aux Énergies Alternatives**
**75015 Paris (FR)**

(72) Inventeur: **ARMANI, Jean-Marc**
**78180 Montigny le Bretonneux (FR)**

(74) Mandataire: **Marks & Clerk France**
**Immeuble "Visium"**
**22, avenue Aristide Briand**
**94117 Arcueil Cedex (FR)**

(56) Documents cités:
**EP-A2- 0 634 835 FR-A1- 3 034 947**
**GB-A- 2 200 520 US-A- 3 956 713**
**US-A- 5 256 860 US-A1- 2005 083 030**
**US-B1- 6 215 302**

EP 3 653 019 B1

**Description**

La présente invention concerne un dispositif de régénération, par chauffage, de composants électroniques soumis à des radiations ionisantes, notamment en environnement nucléaire.

Il est connu que les composants électroniques CMOS sont sensibles aux radiations ionisantes et voient leurs caractéristiques électriques se dégrader après une exposition prolongée. Cette dégradation provient de l'accumulation de charges dans les matériaux isolants du semi-conducteur qui induit un dysfonctionnement des transistors élémentaires. Ces charges piégées sont évacuées à des échelles de temps différentes par émission thermique et/ou effet tunnel. Un recuit à température élevée permet par conséquent de régénérer les composants CMOS de façon plus ou moins complète selon les paramètres de chauffe. Le recuit est généralement appliqué de façon cyclique, avec une durée de fonctionnement du composant régénéré longue devant la durée de la chauffe.

Un régulateur de température précis est indispensable pour contrôler la chauffe du composant pendant la régénération. D'une part, les températures élevées nécessaires doivent être maitrisées au degré près pour atteindre les niveaux d'énergie d'activation des charges piégées visés par la régénération. D'autre part, il est indispensable que la température reste stable durant la régénération et ne s'emballe pas malgré l'irradiation afin de ne pas mettre en danger le composant chauffé. Un réglage de la température est nécessaire pour pouvoir s'adapter aux différents types de composants à régénérer. Il est de plus indispensable de maîtriser la consigne de température qui doit par ailleurs être adapté à chaque type de composant comme rappelé ci-avant. Généralement les dispositifs de régulation de température sont :

- soit conçus pour avoir une grande précision grâce à l'utilisation de composants électroniques complexes (convertisseurs analogique-numérique et numérique-analogique, microcontrôleurs, amplificateurs opérationnels, références de tension intégrées, ...) ;
- soit conçus de façon basique avec quelques composants pour être robustes mais peu précis.

Les solutions complexes peuvent présenter des problèmes d'intégration dans les équipements embarqués et les solutions simples peuvent ne pas être assez performantes pour une application requérant de la précision. Enfin ces dispositifs ne sont classiquement pas prévus pour résister aux environnements nucléaires.

Dans ce type d'environnement, le système de production de la puissance et de régulation de la chauffe peut être par simplicité déporté dans une zone non radioactive pour des raisons de tenue aux radiations. Cependant, ce déport présente certains inconvénients :

- nombre de fils plus importants dans le câble ;
- instabilité possible de la régulation ;
- moindre fiabilité : si la liaison est rompue (câble endommagé), la régénération ne se fait plus ;
- puissance de chauffe pouvant être limitée par les pertes ohmiques.

FR 3 034 947 A1 décrit un dispositif de régénération par chauffage de composants électroniques soumis à des radiations ionisantes comportant une résistance de chauffe.

Un but de l'invention est notamment de répondre à la problématique globale exposée ci-dessus en permettant de réguler localement la température de régénération de composants électroniques de façon précise dans un équipement embarqué soumis à des radiations, tout en maîtrisant la consigne de température réglée en fonction du type de composant à régénérer.

A cet effet, l'invention a pour objet un dispositif de régénération par chauffage de composants électroniques soumis à des radiations ionisantes, comportant au moins les composants suivants :

- une résistance de chauffe, destinée à chauffer un composant à régénérer ;
- une source de courant ;
- une thermistance, reliée à ladite source de courant, couplée thermiquement à ladite résistance de chauffe, ladite thermistance parcourue par ledit courant présentant une tension Vtemp à ses bornes, image de la température de ladite résistance de chauffe ;
- un amplificateur d'erreur amplifiant la différence entre la tension Vset et la tension Vtemp, délivrant une tension Vctrl correspondant à ladite différence amplifiée ;
- un commutateur, commutant le courant passant dans ladite résistance de chauffe ;
- un oscillateur délivrant une tension Vosc formée à rapport cyclique modulé, le rapport cyclique des impulsions de ladite tension Vosc étant fonction de la tension Vctrl, lesdites impulsions commandant l'ouverture dudit commutateur.

Dans un mode de mise en œuvre particulier, ledit dispositif comporte un module de consigne délivrant une tension Vset réglable, image de la température de consigne de chauffe choisie pour ladite résistance de chauffe.

Lesdits composants sont par exemple réalisés en composants électroniques discrets.

Dans un autre mode de réalisation possible, ledit dispositif comporte un régulateur de tension fournissant une tension d'alimentation stabilisée à ladite source de courant, audit amplificateur et audit module de consigne. Ledit dispositif comporte par exemple un circuit de sécurité formé par un transistor Q1, une résistance Rlim et un potentiomètre Plim, la résistance Rlim et le potentiomètre Plim étant reliés en pont diviseur à une tension stabilisée Vreg alimentant ledit oscillateur, le point milieu dudit pont étant relié sur la base du transistor Q1, l'émetteur du transistor Q1 étant relié à l'entrée dudit oscillateur recevant la tension Vctrl et le collecteur étant relié à ladite tension stabilisée Vreg.

Ledit commutateur comporte par exemple deux transistors bipolaires Q3, Q4 et des résistances R7, R8, R9, R10, lesdits transistors étant assemblés de sorte que quand Q3 est passant, Q4 est passant, la base de Q4 étant reliée au collecteur du transistor Q3 à travers la résistance R9, la résistance R10 étant connectée entre émetteur et base de Q4, l'émetteur de Q4 étant directement relié à une tension d'alimentation Vcc, et son collecteur à ladite résistance de chauffe, l'émetteur de Q3 étant relié à la masse électrique, et sa base au point milieu d'un diviseur de tension constitué par les résistances R7 et R8, la résistance R7 étant reliée à la sortie dudit oscillateur, délivrant la tension Vosc, et la résistance R8 étant reliée à la masse électrique.

Ladite source de courant comporte par exemple :

- un miroir de courant équilibré à quatre transistors bipolaires, formant un miroir de Wilson complet ;
- une résistance R6 ;
- une résistance Rshunt ;
- et une résistance Rbias1 ;

l'ensemble des quatre transistors formant deux miroirs de courant simples M1, M2 branchés en cascade et croisés de telle sorte que les courants de base des transistors tendent à s'annuler, les émetteurs des transistors du premier miroir M1 étant aptes à être reliés à une tension régulée Vreg, le deuxième miroir M2 étant relié en sortie à la résistance Rshunt, reliée à la résistance de ladite thermistance (10), et à la résistance Rbias1, reliée à la masse électrique, la résistance R6 reliant les émetteurs des transistors du premier miroir M1 à leur base commune.

La valeur de la résistance R6 est par exemple sensiblement la moitié de la valeur de la résistance Rbias1.

Ledit amplificateur comporte par exemple au moins :

- une première paire différentielle DP2 à transistors bipolaires complémentaires formant un premier étage d'amplification, recevant la tension Vtemp sur la base d'un transistor et la tension Vset sur la base de l'autre transistor ;
- un miroir de courant M4 fixant le courant de polarisation de DP2 ;
- une deuxième paire différentielle DP1 à transistors bipolaires complémentaires formant un deuxième étage d'amplification, la base d'un premier transistor de DP1 étant reliée au collecteur d'un premier transistor de DP2 et la base du deuxième transistor de DP1 étant reliée au collecteur du deuxième transistor de DP2 ;
- un miroir de courant M3 fixant le courant de polarisation de DP1 ;
- un transistor bipolaire Q2 formant le troisième étage d'amplification, la base de Q2 étant reliée au collecteur d'un transistor de DP1, le collecteur de Q2 étant apte à être relié à une tension régulée Vreg, la tension Vctrl étant présente en sortie de l'émetteur de Q2.

Ledit amplificateur comporte par exemple des résistances R1, R2, R3, R4, R5 et des résistances Rbias2, Rbias3, les émetteurs des transistors du miroir de courant M3 étant aptes à être reliés à la tension régulée Vreg, le collecteur d'un transistor du miroir M3 étant reliée à la résistance Rbias2 et le collecteur de l'autre transistor du miroir M3 étant relié aux émetteurs des transistors de la première paire différentielle DP1, les collecteurs du miroir M3 étant reliés à la masse via les résistances R3 et R4, les émetteurs du miroir M4 étant reliés à la masse, un collecteur dudit miroir M4 étant apte à être relié à la tension régulée Vreg via la résistance Rbias3 et l'autre collecteur étant relié aux émetteurs de la paire différentielle DP2, les collecteurs de DP2 étant reliés à la tension régulée Vreg, via la résistance R1 pour l'un et via la résistance R2 pour l'autre, le collecteur du transistor Q2 étant apte à être relié à la tension régulée Vreg, l'émetteur de Q2 étant relié à la masse via la résistance R5.

Ledit oscillateur comporte par exemple des transistors bipolaires Q5, Q6, Q7, Q8, des résistances R11, R12, R13, R14, R15, R16, R17, R18, R19, R20, R21 et un condensateur C1 assemblés pour former un oscillateur à relaxation, la fréquence d'oscillation libre étant déterminée par la résistance R12, connectée entre ledit condensateur C1 et l'émetteur de Q8 formant la sortie dudit oscillateur ;

- le courant de charge du condensateur C1 étant commandé pour moduler le rapport cyclique de la tension Vosc délivrée en sortie dudit oscillateur, ledit courant de charge étant fourni par la tension Vctrl via la résistance R11 ;
- ledit oscillateur étant alimenté électriquement par une tension régulée Vreg à laquelle sont reliées les résistances R13, R14, R15, reliées respectivement au collecteur de Q5, Q6 et Q7, et le collecteur du transistor Q8 ;
- les transistors Q5 et Q6, et les résistances R13, R14, R16, R17 et R19 formant une bascule de type trigger de schmitt, le signal aux bornes dudit condensateur C1 étant envoyé sur la base du transistor Q5 constituant l'entrée de ladite bascule ;
- la sortie de ladite bascule, formée par le collecteur de Q6, étant envoyée sur un inverseur formé par le transistor Q7 et les résistances R15, R18 et R20, R18 étant connectée entre la base de Q7 et le collecteur de Q6 et R20 étant connectée entre ladite base et la masse électrique ;
- le signal inversé étant prélevé sur le collecteur du transistor Q7 et étant envoyé sur un étage d'adaptation d'impédance constitué par le transistor Q8, monté en suiveur, et la résistance R21 configurés en montage collecteur commun.

Ledit dispositif comporte par exemple une sortie fournissant un signal VTout de recopie de la tension aux bornes de ladite thermistance.

Le dispositif selon l'invention permet avantageusement d'améliorer la précision de la régulation de la température par rapport à des solutions fonctionnant en tout ou rien pour lesquelles la température peut varier très sensiblement par rapport à la valeur souhaitée.

D'autres caractéristiques et avantages de l'invention apparaîtront à l'aide de la description qui suit, faite en regard de dessins annexés qui représentent :

- la figure 1, un exemple de schéma fonctionnel de l'invention ;
- la figure 2, un exemple de réalisation d'un dispositif selon l'invention ;
- la figure 3, un exemple de réalisation d'un oscillateur de type PWM utilisé dans un dispositif selon l'invention.

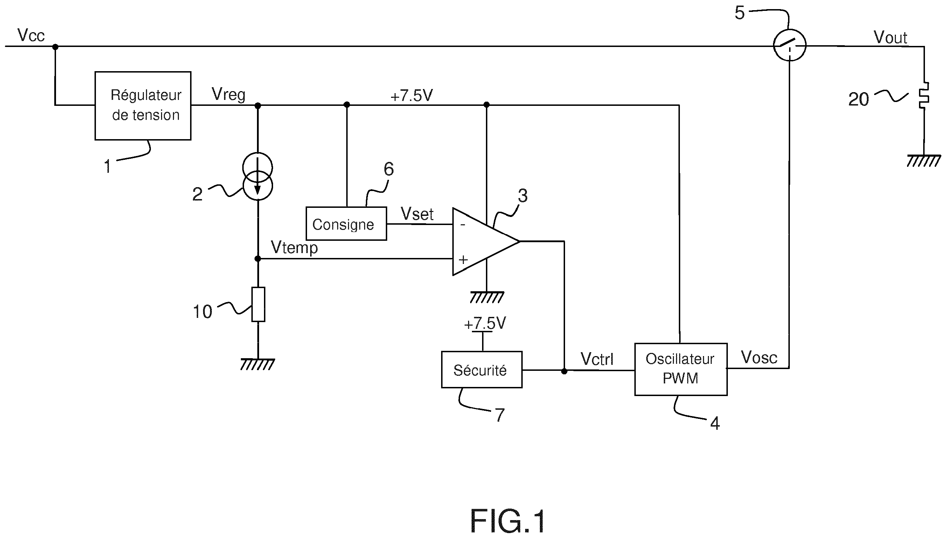

La figure 1 présente un exemple de schéma fonctionnel de l'invention. Dans ce schéma, le dispositif comporte les composants suivants :

- un régulateur de tension 1 formant une alimentation stabilisée ;
- une source de courant de précision 2 ;
- un amplificateur d'erreur 3 à grand gain ;
- un oscillateur 4 piloté par modulation du rapport cyclique de ses impulsions, appelée PWM ;
- un module 6 de réglage de la température de consigne, réalisé par exemple par un pont de résistances ;
- un système de sécurité thermique 7 ;
- un capteur de température 10, du type thermistance ;
- une résistance de chauffe 20, destinée à chauffer le composant à régénérer ;
- un commutateur 5, commutant le courant passant dans la résistance de chauffe.

On décrit par la suite le fonctionnement du dispositif de la figure 1, et la fonction des composants listés ci-dessus.

Le capteur de température 10, représenté par sa résistance, et la résistance de chauffe 20 sont reliés thermiquement ensemble sur le composant à régénérer. Pour réaliser ce couplage thermique, un adhésif composite thermiquement conducteur et électriquement isolant peut être utilisé. Pour effectuer ce couplage thermique au composant à régénérer, le capteur 10 et la résistance de chauffe 20 sont éloignés de l'ensemble des autres composants du dispositif.

Le dispositif selon l'invention est alimenté par une tension d'entrée continue Vcc, par exemple égale à 12 V nominale. Le régulateur de tension 1 transforme cette tension en une tension régulée Vreg par exemple égale à 7,5 V. Cette tension régulée alimente le générateur de courant 2, l'amplificateur d'erreur 3, le pont de réglage de la température 6, la sécurité thermique 7, et l'oscillateur modulé 4. Le commutateur 5 du courant de chauffe est quant à lui directement alimenté par la tension d'entrée Vcc, non régulée. Le régulateur selon l'invention est réalisé au moyen de composants discrets tels que des transistors, diodes, résistances et condensateurs afin de garantir une bonne tenue aux radiations. Ce régulateur permet de s'affranchir des variations de la tension d'entrée Vcc tout en fournissant en sortie une tension précise.

La source de courant 2 alimente le capteur de température 10 avec un courant stable et précis. Ceci permet de déduire directement la température à partir de la tension Vtemp mesurée aux bornes dudit capteur.

Le module de réglage de la consigne 6 permet de fixer la température de régulation. Il envoie cette consigne à l'amplificateur d'erreur 3 sous forme d'une tension Vset.

L'amplificateur d'erreur 3 a notamment pour fonction d'amplifier la différence entre la tension de consigne Vset et la tension Vtemp aux bornes du capteur. Il fournit un signal d'erreur amplifié Vctrl au circuit de sécurité thermique 7 et à l'oscillateur modulé 4.

Cet oscillateur 4 permet de faire varier la puissance envoyée sur la résistance de chauffe 20 en ajustant le rapport cyclique de la tension appliquée, ou du courant parcourant cette résistance. Il envoie un signal de commande Vosc au commutateur 5.

La sécurité thermique 7 permet de protéger le composant à régénérer, en limitant la température de chauffe à une valeur maximale préréglée.

Le commutateur 5 du courant de chauffe hache (ou commute) le courant prélevé sur l'alimentation non régulée Vcc pour l'envoyer sur la résistance de chauffe 20.

Les différentes fonctions du dispositif sont réalisées à base de composants discrets car ceci permet d'avoir le contrôle sur le choix et la configuration de ces composants pour la définition d'une architecture capable de garantir une bonne tenue aux radiations. Notamment, les transistors peuvent être choisis dans la gamme des modèles bipolaires discrets, plus résistants aux radiations que les MOSFETs discrets.

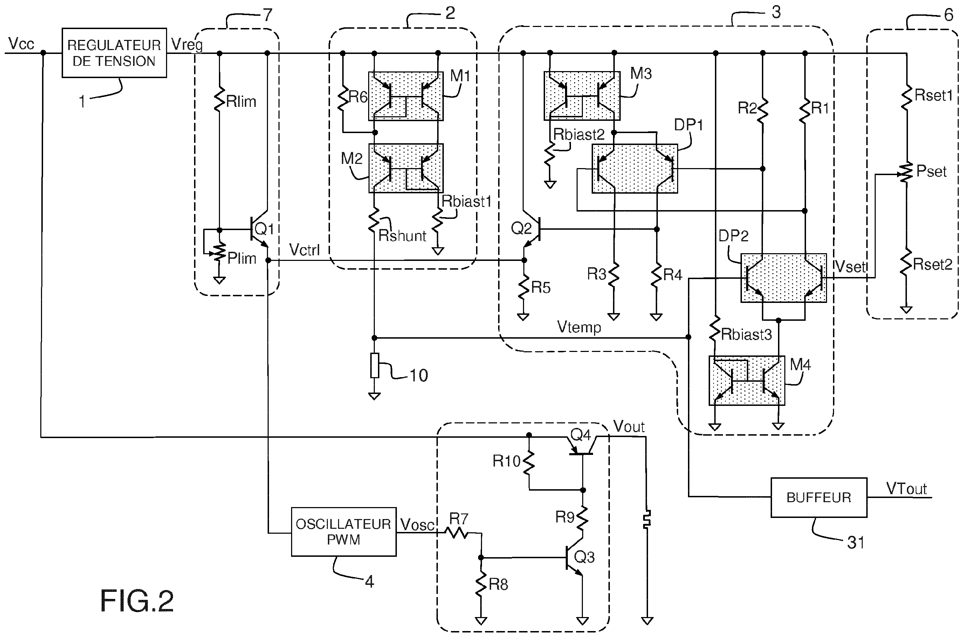

La figure 2 présente un exemple de réalisation d'un dispositif selon l'invention. Cette figure détaille les différents éléments listés sur la figure 1. On décrit maintenant plus en détail les différents composants constitutifs du dispositif selon l'invention.

La température de consigne est fixée par l'intermédiaire d'un pont résistif 6 composé d'une résistance Rset1, d'un potentiomètre Pset et d'une autre résistance Rset2. Le pied du pont diviseur est relié à la masse du circuit et le signal de consigne Vset présent sur le curseur du potentiomètre Pset est envoyé sur une entrée de l'amplificateur d'erreur 3. Un opérateur peut régler la température de consigne en agissant sur le potentiomètre, directement ou par toute interface connue par ailleurs. Il est ainsi possible de remplacer le pont résistif par un générateur de tension commandé par exemple. On règle également Vset en fonction des caractéristiques du capteur de température 10 utilisé.

La valeur ohmique des trois éléments Rset1, Pset, Rset2 est choisie de telle façon que l'on puisse négliger le courant circulant dans la branche délivrant la tension de consigne VSet. Dans ce cas, la tension Vset est donnée par l'équation suivante :

$$Vset = Vreg * \frac{Rset2 + \propto * Pset}{Rset1 + Pset + Rset2}$$

Le paramètre $\alpha$ représente le rapport de division du potentiomètre Pset pour un réglage donné. Les résistances Rset1 et Rset2 permettent de limiter la gamme de réglage de la température de consigne.

Le générateur de courant 2 est un générateur de courant de précision, robuste aux variations de température et aux variations technologiques dues au procédé de fabrication des composants (transistors dans les paires M1 et M2). Il est bâti autour d'un miroir de courant équilibré à quatre transistors bipolaires, formant un miroir de Wilson complet. A cet effet, l'ensemble des quatre transistors forme deux miroirs de courant simples M1, M2 branchés en cascade et croisés de telle sorte que les courants de base des transistors tendent à s'annuler. Les émetteur des transistors du premier miroir M1 sont reliés à la tension régulée Vreg. Le deuxième miroir M2 est relié en sortie à une résistance Rshunt, reliée à la résistance du capteur de température 10, et à une résistance Rbias1, reliée à la masse. Plus précisément, le collecteur d'un transistor est relié à Rshunt et le collecteur de l'autre transistor est relié à Rbias1. Une résistance R6 relie les émetteurs des transistors du premier miroir M1 à leur base commune.

Les transistors de ces miroirs simples sont appariés deux à deux et chaque paire est par exemple intégrée dans un boitier commun pour assurer un bon couplage thermique. Il est également possible d'utiliser des quadruplets de transistors identiques dans un même boitier afin d'encore améliorer les performances thermiques. En première approximation, si l'on considère tous les transistors du premier miroir M1 et du deuxième miroir M2 identiques, le courant de mesure $I_{sensor}$ de la résistance du capteur de température 10 est égal au courant circulant dans la résistance Rbias1 et est donné par l'équation suivante :

$$Isensor = \frac{Vreg - Vbe(M1) - Vbe(M2)}{Rbias1} + \frac{Vbe(M1)}{R6}$$

*Vbe*(*M*1) et *Vbe*(*M*2) représentent respectivement la tension entre la base et l'émetteur des transistors des miroirs M1 et M2.

La résistance R6 permet de compenser en partie les variations du courant de mesure lorsque la température ambiante change. Pour cela, la valeur de la résistance R6 doit être la moitié de celle de la résistance Rbias1. En considérant tous les transistors identiques, l'équation précédente devient alors :

$$Isensor = \frac{Vreg + Vbe(M1) - Vbe(M2)}{Rbias1} \approx \frac{Vreg}{Rbias1}$$

Le courant de mesure est donc au premier ordre indépendant de la température. Afin de ne pas provoquer d'auto échauffement du capteur qui pourrait induire une erreur, le courant de mesure est fixé à une valeur telle que la puissance dissipée dans celui-ci reste suffisamment basse (inférieure à quelques mW). La résistance Rshunt permet de mesurer le courant de mesure sans avoir à déconnecter le capteur afin d'ajuster son intensité à l'aide de Rbias1.

L'amplificateur d'erreur 3 comporte des paires différentielles DP1, DP2 à transistors bipolaires complémentaires, des miroirs de courant M3, M4 à transistors bipolaires complémentaires, un transistor bipolaire Q2, des résistances R1, R2, R3, R4, R5 et des résistances Rbias2, Rbias3.

Les émetteurs des transistors du premier miroir de courant M3 sont reliés à la tension régulée Vreg. Le collecteur d'un transistor est relié à la résistance Rbias2 et le collecteur de l'autre transistor est relié aux émetteurs des transistors de la première paire différentielle DP1, les collecteurs étant reliés à la masse via les résistances R3 et R4.

Le miroir de courant M3 est ainsi connecté de telle façon qu'il fixe le courant de polarisation de la paire DP1. Ceci permet d'améliorer la précision de la régulation de température en renforçant la réjection du mode commun.

Si on suppose les deux transistors de M3 identiques, le courant *IbiasDP*1 que celui-ci fournit à la paire DP1 est donné par l'équation suivante, équation de base d'un miroir de courant :

$$IbiasDP1 = \frac{Vreg - Vbe(M3)}{Rbias2 * \left[1 + \dfrac{2}{\beta(M3)}\right]}$$

*Vbe(M3)* représente la tension base-émetteur des transistors du miroir M3. $\beta$*(M3)* est le gain statique en courant des transistors du miroir.

Le deuxième miroir de courant M4 et la deuxième paire différentielle DP2 sont connectés de manière similaire. Dans ce montage, les émetteurs du miroir M4 sont reliés à la masse, un collecteur est relié à la tension régulée Vreg via la résistance Rbias3 et l'autre collecteur est relié aux émetteurs de la paire différentielle DP2. Les collecteurs de cette paire DP2 sont reliés à la tension régulée, via la résistance R1 pour l'un et via la résistance R2 pour l'autre.

La paire différentielle DP2 constitue le premier étage de l'amplification, elle reçoit la tension Vtemp sur la base d'un transistor et la tension Vset sur la base de l'autre transistor.

La paire différentielle DP1 constitue le deuxième étage de l'amplification. A cet effet, la base du premier transistor de DP1 est reliée au collecteur du premier transistor de DP2 et que la base du deuxième transistor de DP1 est reliée au collecteur du deuxième transistor de DP2.

Le transistor Q2 constitue le troisième étage de l'amplification, à cet effet, la base de Q2 est reliée au collecteur d'un transistor de DP1. Le collecteur de Q2 est relié à la tension régulée Vreg et son émetteur est relié à la masse via la résistance R5.

Etant donné que le miroir de courant M4 et la paire différentielle DP2 sont connectés de façon similaire, la même forme d'équation permet de calculer le courant *IbiasDP*2 fourni à DP2 par M4.

Le gain différentiel de la paire DP1 est fixé par le courant de repos *IbiasDP1* ainsi que les résistances R1et R2. Si l'on donne à R1 et R2 une valeur identique notée RC1, le gain différentiel *Avdif*(DP1) est donné par l'équation suivante :

$$Avdif(DP1) = gm(DP1) * RC1 = \frac{IbiasDP1 * RC1}{2 * VT}$$

gm(DP1) est la transconductance des transistors de DP1, VT est le potentiel thermique du transistor qui vaut environ 26 mV à 300K. La même forme d'expression permet de calculer le gain différentiel de la paire DP2. Comme on prélève la tension sur la paire DP2 en mode commun et non différentiel, il faut considérer le gain en mode commun *Avcom(DP2)* qui est égal au gain différentiel divisé par 2.

Le gain total en boucle ouverte de l'amplificateur d'erreur *Av(Amplifier)* dépend de la contribution des trois étages DP2, DP1 et Q2 et est donc égal à *Avdif(DP1)\*AVcom(DP2)\*Av(Q2)*.

En approximant le gain *Av(Q2)* de Q2 à 1, et en négligeant les pertes, l'expression peut s'écrire :

$$Av(Amplifier) = \frac{gm(DP1) * RC1 * gm(DP2) * RC2}{2}$$

RC2 est la valeur des résistances R3 et R4.

Le gain de l'amplificateur d'erreur *Av(Amplifier)* est préférablement configuré à une valeur élevée pour avoir une erreur minimale en boucle fermée.

La sortie de l'amplificateur d'erreur est l'émetteur du transistor Q2 qui fournit une tension de contrôle Vctrl. Cette tension est envoyée sur l'oscillateur 4 dont le rapport cyclique est modulable (PWM). Le PWM permet de minimiser l'échauffement des transistors du commutateur 5 qui fonctionnent en mode bloqué-saturé. Il procure un contrôle précis de la température grâce à la variation continue de la puissance envoyée dans la résistance de chauffe 20 (Rheat). Cette puissance dépend de façon linéaire du rapport cyclique du signal en sortie de l'oscillateur selon l'expression :

$$Pheat = \frac{Vcc^2}{Rheat} * Dcycl$$

Dcycl est le rapport cyclique du signal en sortie de l'oscillateur, et correspond au quotient de la largeur d'impulsion sur la période. Si l'oscillateur présente une fonction de transfert linéaire, alors la puissance varie également linéairement par rapport à la tension Vctrl.

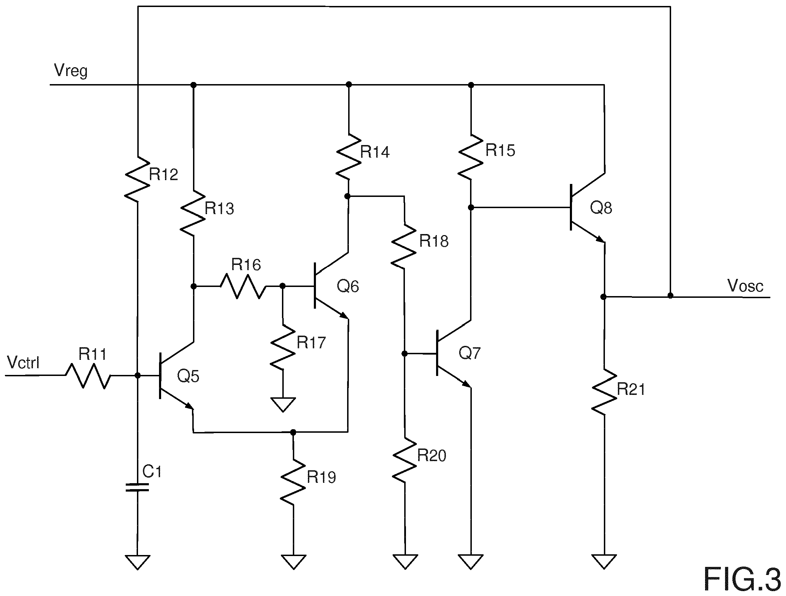

La figure 3 présente un exemple de réalisation de cet oscillateur. D'autres implémentations sont possibles, comportant plus ou moins de composants.

Cet exemple de réalisation comprend quatre transistors bipolaires Q5, Q6, Q7, Q8, dix résistances R11 à R21 et un condensateur C1. Les éléments sont assemblés pour former un oscillateur à relaxation dont on pilote le courant de charge du condensateur C1 pour moduler le rapport cyclique en sortie de l'oscillateur. La tension Vosc délivrée en sortie est ainsi modulée par la variation de son rapport cyclique. Le courant de charge du condensateur C1 est contrôlé par la tension Vctrl via la résistance R11. L'oscillateur est alimenté par la tension régulée Vreg à laquelle sont reliées les résistances R13, R14, R15 (reliées respectivement au collecteur de Q5, Q6 et Q7) et le collecteur du transistor Q8.

La fréquence d'oscillation libre est imposée par la résistance R12 et le condensateur C1. Cette fréquence peut être aisément fixée à plusieurs dizaines de kilohertz.

Les transistors Q5 et Q6, ainsi que les résistances R13, R14, R16, R17 et R19 forment une bascule trigger de schmitt. Les seuils de cette bascule sont fixés de façon à réduire le risque d'oscillation de la boucle de régulation de température.

Le signal aux bornes de la capacité C1 est envoyé sur la base du transistor Q5 constituant l'entrée de cette bascule trigger. La sortie de cette bascule, prélevée sur le collecteur de Q6 est envoyée sur un inverseur formé par le transistor Q7 et les résistances R15, R18 et R20. La résistance R20, connectée en pied de pont R18/R20, permet d'améliorer la commutation du transistor Q7 (R18 étant connectée entre la base de Q7 et le collecteur de Q6 et R20 étant connectée entre ladite base et la masse).

Le signal inversé est prélevé sur le collecteur du transistor Q7 et est envoyé sur un étage d'adaptation d'impédance constitué par le transistor Q8, monté en suiveur, et la résistance R21 configurés en montage collecteur commun. La sortie de l'oscillateur Vosc est prélevée sur l'émetteur de Q8 et est rebouclée sur l'entrée à travers la résistance R12 afin de créer une oscillation entretenue.

Lorsque l'entrée Vctrl est déconnectée, l'oscillateur fournit un signal avec un rapport cyclique moyen. Quand une tension est appliquée sur l'entrée Vctrl, les temps de charge et de décharge de la capacité C1 vont être modifiés par la valeur de cette tension, ce qui va modifier le rapport cyclique de la sortie Vosc. Le montage est configuré de sorte que lorsque Vctrl augmente, le rapport cyclique de Vosc diminue.

Le signal Vosc provenant de la sortie de l'oscillateur modulé est utilisé pour piloter le commutateur 5 du courant envoyé dans la résistance de chauffe 20. Le commutateur est constitué par deux transistors bipolaires Q3, Q4 ainsi que par des résistances R7, R8, R9, R10. Les transistors sont assemblés de sorte que quand Q3 est passant, Q4 l'est aussi. Q4 est un transistor PNP de puissance dont les caractéristiques permettent de laisser passer le courant de chauffe nécessaire à la régénération. Il présente une tension de saturation faible sous un fort courant de collecteur. Sa base est reliée au collecteur du transistor NPN Q3 à travers la résistance R9. Cette dernière doit avoir une valeur suffisamment faible pour assurer une bonne saturation de Q4, même lorsque l'intensité du courant de chauffe est élevée. La résistance R10 placée entre émetteur et base de Q4 permet d'améliorer la commutation de ce dernier. L'émetteur de Q4 est directement relié à la tension Vcc, et son collecteur à la résistance de chauffe. L'émetteur de Q3 est relié à la masse, et sa base au point milieu d'un diviseur de tension constitué par les résistances R7 et R8. La résistance R7, reliée à la sortie de l'oscillateur, fixe le courant de base de Q3 et la résistance R8 permet d'améliorer les commutations de Q3.

Afin de protéger le composant à régénérer, un circuit sécurité 7 sur la température de chauffe est par exemple prévu. Le circuit de protection est formé par un transistor Q1, une résistance Rlim et un potentiomètre Plim.

La résistance Rlim et le potentiomètre Plim sont reliés en pont diviseur à la tension régulée Vreg. Le point milieu de ce pont est relié sur la base de Q1. La valeur ohmique de Rlim et de Plim sont choisies de façon à ce que le courant circulant dans la base de Q1 puisse être négligé. L'émetteur de Q1 est relié au signal Vctrl (plus précisément à la sortie de l'amplificateur 3 et à l'entrée de l'oscillateur 4) et son collecteur est relié à la tension Vreg. Ce circuit 7 permet de limiter la température maximale que peut réguler l'invention. Pour cela, il agit sur la tension Vctrl en l'empêchant de descendre en dessous d'une valeur déterminée par le réglage de Plim. L'oscillateur PWM ne peut donc pas atteindre les rapports cycliques qui génèreraient une puissance trop importante en sortie. La valeur *Vlim* de tension de sécurité est donnée par l'expression :

$$Vlim = \frac{Vreg * \beta * Plim}{\beta * Plim + Rlim} - Vbe(Q1)$$

*Vbe*(Q1) est la tension entre la base et l'émetteur de Q1.

Le paramètre $\beta$ est le coefficient donnant la valeur de résistance de Plim configuré en résistance variable. Lorsque $\beta$ est réglé de telle façon que le premier terme de l'équation ci-dessus soit inférieur ou égal au second terme, la sécurité est mise hors service et la température de régulation n'a pas de limitation.

Dans une variante de réalisation, le dispositif fournit un signal VTout proportionnel à la température de régulation. Ce signal est la recopie de la tension aux bornes du capteur de température 10. Ce signal VTout permet à un utilisateur de connaitre à tout moment la température du composant en cours de régénération. Par défaut VTout est sortie directement, c'est-à-dire sous haute impédance. Si l'application impose un signal à basse impédance, il est possible d'ajouter un adaptateur d'impédance optionnel 31, comme dans l'exemple de la figure 2. Cet adaptateur d'impédance, encore appelé buffer, est constitué par des composants discrets tels que transistors, diodes, résistances et condensateurs afin de garantir une bonne tenue aux radiations.

Les composant du dispositif selon l'invention peuvent tous être implantés sur un même circuit imprimé, à l'exception du capteur de température 10 et de la résistance de chauffe 20, tous deux couplés thermiquement au composant à régénérer. Les liaisons entre la thermistance 10 et la résistance de chauffe d'une part et les autres composants du dispositif sont de type filaire. Les fils de liaison peuvent être torsadés pour filtrer les tensions parasites induites par l'environnement.

Eventuellement, le régulateur de tension 1 peut être exclu du dispositif selon l'invention, la tension régulée stabilisée étant alors fournie par un régulateur de tension extérieur.

Dans une variante de réalisation, les composants discrets du dispositif des figures 1 et 2 peuvent être remplacés en totalité ou en partie par un circuit intégré spécifique (ASIC) reprenant les blocs fonctionnels décrits précédemment. Dans ce cas, il faut prévoir des adaptations complémentaires aux différents circuits constituant le dispositif illustré par la figure 1.

## Revendications

1. Dispositif de régénération par chauffage de composants électroniques soumis à des radiations ionisantes, comportant :

   - une résistance de chauffe (20), destinée à chauffer un composant à régénérer ; et
   - une source de courant (2) ; ledit dispositif étant **caractérisé en ce qu'**il comporte en outre au moins les composants suivants :
   - une thermistance (10), reliée à ladite source de courant (2), couplée thermiquement à ladite résistance de chauffe, ladite thermistance parcourue par ledit courant présentant une tension Vtemp à ses bornes, image de la température de ladite résistance de chauffe (20) ;
   - un amplificateur d'erreur (3) amplifiant la différence entre une tension de consigne Vset et la tension Vtemp, délivrant une tension Vctrl correspondant à ladite différence amplifiée ;
   - un commutateur (5), commutant le courant passant dans ladite résistance de chauffe (20) ; et
   - un oscillateur (4) délivrant une tension Vosc formée à rapport cyclique modulé, le rapport cyclique des impulsions de ladite tension Vosc étant fonction de la tension Vctrl, lesdites impulsions commandant l'ouverture dudit commutateur (5).

2. Dispositif selon la revendication 1, **caractérisé en ce qu'**il comporte un module de consigne (6) délivrant une tension Vset réglable, image de la température de consigne de chauffe choisie pour ladite résistance de chauffe (20).

3. Dispositif selon l'une quelconque des revendications précédentes, **caractérisé en ce que** lesdits composants sont réalisés en composants électroniques discrets.

4. Dispositif selon l'une quelconque des revendications précédentes, **caractérisé en ce qu'**il comporte un régulateur de tension (1) fournissant une tension d'alimentation stabilisée à ladite source de courant (2), audit amplificateur (3) et audit module de consigne (6).

5. Dispositif selon l'une quelconque des revendications précédentes, **caractérisé en ce qu'**il comporte un circuit de sécurité (7) formé par un transistor Q1, une résistance Rlim et un potentiomètre Plim, la résistance Rlim et le potentiomètre Plim étant reliés en pont diviseur à une tension stabilisée Vreg alimentant ledit oscillateur (4), le point milieu dudit pont étant relié sur la base du transistor Q1, l'émetteur du transistor Q1 étant relié à l'entrée dudit oscillateur (4) recevant la tension Vctrl et le collecteur étant relié à ladite tension stabilisée Vreg.

6. Dispositif selon l'une quelconque des revendications précédentes, **caractérisé en ce que** ledit commutateur (5) comporte deux transistors bipolaires Q3, Q4 et des résistances R7, R8, R9, R10, lesdits transistors étant assemblés de sorte que quand Q3 est passant, Q4 est passant, la base de Q4 étant reliée au collecteur du transistor Q3 à travers la résistance R9, la résistance R10 étant connectée entre émetteur et base de Q4, l'émetteur de Q4 étant directement relié à une tension d'alimentation Vcc, et son collecteur à ladite résistance de chauffe, l'émetteur de Q3 étant relié à la masse électrique, et sa base au point milieu d'un diviseur de tension constitué par les résistances R7 et R8, la résistance R7 étant reliée à la sortie dudit oscillateur (4), délivrant la tension Vosc, et la résistance R8 étant reliée à la masse électrique.

7. Dispositif selon l'une quelconque des revendications précédentes, **caractérisé en ce que** ladite source de courant (2) comporte :

   - un miroir de courant équilibré à quatre transistors bipolaires, formant un miroir de Wilson complet ;
   - une résistance R6 ;
   - une résistance Rshunt ;
   - et une résistance Rbias1 ;

   l'ensemble des quatre transistors formant deux miroirs de courant simples M1, M2 branchés en cascade et croisés de telle sorte que les courants de base des transistors tendent à s'annuler, les émetteurs des transistors du premier miroir M1 étant aptes à être reliés à une tension régulée Vreg, le deuxième miroir M2 étant relié en sortie à la résistance Rshunt, reliée à la résistance de ladite thermistance (10), et à la résistance Rbias1, reliée à la masse électrique, la résistance R6 reliant les émetteurs des transistors du premier miroir M1 à leur base commune.

8. Dispositif selon la revendication 7, **caractérisé en ce que** la valeur de la résistance R6 est sensiblement la moitié de la valeur de la résistance Rbias1.

9. Dispositif selon l'une quelconque des revendications précédentes, **caractérisé en ce que** ledit amplificateur (3) comporte au moins :

   - une première paire différentielle DP2 à transistors bipolaires complémentaires formant un premier étage d'amplification, recevant la tension Vtemp sur la base d'un transistor et la tension Vset sur la base de l'autre transistor ;
   - un miroir de courant M4 fixant le courant de polarisation de DP2 ;
   - une deuxième paire différentielle DP1 à transistors bipolaires complémentaires formant un deuxième étage d'amplification, la base d'un premier transistor de DP1 étant reliée au collecteur d'un premier transistor de DP2 et la base du deuxième transistor de DP1 étant reliée au collecteur du deuxième transistor de DP2 ;
   - un miroir de courant M3 fixant le courant de polarisation de DP1 ;
   - un transistor bipolaire Q2 formant le troisième étage d'amplification, la base de Q2 étant reliée au collecteur d'un transistor de DP1, le collecteur de Q2 étant apte à être relié à une tension régulée Vreg, la tension Vctrl étant présente en sortie de l'émetteur de Q2.

10. Dispositif selon la revendication 9, caractérisé que ledit amplificateur comporte des résistances R1, R2, R3, R4, R5 et des résistances Rbias2, Rbias3, les émetteurs des transistors du miroir de courant M3 étant aptes à être reliés à la tension régulée Vreg, le collecteur d'un transistor du miroir M3 étant reliée à la résistance Rbias2 et le collecteur de l'autre transistor du miroir M3 étant relié aux émetteurs des transistors de la première paire différentielle DP1, les collecteurs du miroir M3 étant reliés à la masse via les résistances R3 et R4, les émetteurs du miroir M4 étant reliés à la masse, un collecteur dudit miroir M4 étant apte à être relié à la tension régulée Vreg via la résistance Rbias3 et l'autre collecteur étant relié aux émetteurs de la paire différentielle DP2, les collecteurs de DP2 étant reliés à la tension régulée Vreg, via la résistance R1 pour l'un et via la résistance R2 pour l'autre, le collecteur du transistor Q2 étant apte à être relié à la tension régulée Vreg, l'émetteur de Q2 étant relié à la masse via la résistance R5.

11. Dispositif selon l'une quelconque des revendications précédentes, **caractérisé en ce que** ledit oscillateur (4) comprend des transistors bipolaires Q5, Q6, Q7, Q8, des résistances R11, R12, R13, R14, R15, R16, R17, R18, R19, R20, R21 et un condensateur C1 assemblés pour former un oscillateur à relaxation, la fréquence d'oscillation libre étant déterminée par la résistance R12, connectée entre ledit condensateur C1 et l'émetteur de Q8 formant la sortie dudit oscillateur ;

- le courant de charge du condensateur C1 étant commandé pour moduler le rapport cyclique de la tension Vosc délivrée en sortie dudit oscillateur, ledit courant de charge étant fourni par la tension Vctrl via la résistance R11 ;
- ledit oscillateur étant alimenté électriquement par une tension régulée Vreg à laquelle sont reliées les résistances R13, R14, R15, reliées respectivement au collecteur de Q5, Q6 et Q7, et le collecteur du transistor Q8 ;
- les transistors Q5 et Q6, et les résistances R13, R14, R16, R17 et R19 formant une bascule de type trigger de schmitt, le signal aux bornes dudit condensateur C1 étant envoyé sur la base du transistor Q5 constituant l'entrée de ladite bascule ;
- la sortie de ladite bascule, formée par le collecteur de Q6, étant envoyée sur un inverseur formé par le transistor Q7 et les résistances R15, R18 et R20, R18 étant connectée entre la base de Q7 et le collecteur de Q6 et R20 étant connectée entre ladite base et la masse électrique ;
- le signal inversé étant prélevé sur le collecteur du transistor Q7 et étant envoyé sur un étage d'adaptation d'impédance constitué par le transistor Q8, monté en suiveur, et la résistance R21 configurés en montage collecteur commun.

12. Dispositif selon l'une quelconque des revendications précédentes, **caractérisé en ce qu'**il comporte une sortie fournissant un signal VTout de recopie de la tension aux bornes de ladite thermistance (10).

**Patentansprüche**

1. Vorrichtung zur Regeneration von elektronischen Komponenten, die ionisierenden Strahlungen ausgesetzt sind, durch Erwärmen, aufweisend:

- einen Heizwiderstand (20), der dazu gedacht ist, eine zu regenerierende Komponente zu erwärmen; und
- eine Stromquelle (2);

wobei die Vorrichtung **dadurch gekennzeichnet ist, dass** sie ferner mindestens die folgenden Komponenten aufweist:

- einen an die Stromquelle (2) angeschlossenen Thermistor (10), der thermisch an den Heizwiderstand gekoppelt ist, wobei der von dem Strom durchflossene Thermistor an seinen Anschlussklemmen eine Spannung Vtemp aufweist, die für die Temperatur des Heizwiderstands (20) steht;
- einen Fehlerverstärker (3), der die Differenz zwischen einer Sollspannung Vset und der Spannung Vtemp verstärkt, wobei er eine Spannung Vctrl abgibt, die der verstärkten Differenz entspricht;
- einen Schalter (5), der den den Heizwiderstand (20) passierenden Strom schaltet; und
- einen Oszillator (4), der eine Spannung Vosc abgibt, die mit einem modulierten Taktverhältnis gebildet wird, wobei das Taktverhältnis der Impulse der Spannung Vosc abhängig ist von der Spannung Vctrl, wobei die Impulse das Öffnen des Schalters (5) steuern.

2. Vorrichtung nach Anspruch 1, **dadurch gekennzeichnet, dass** sie ein Sollwertmodul (6) aufweist, das eine einstellbare Spannung Vset abgibt, die für die Sollheiztemperatur steht, die für den Heizwiderstand (20) ausgewählt wurde.

3. Vorrichtung nach einem der vorhergehenden Ansprüche, **dadurch gekennzeichnet, dass** die Komponenten als diskrete elektronische Komponenten umgesetzt sind.

4. Vorrichtung nach einem der vorhergehenden Ansprüche, **dadurch gekennzeichnet, dass** sie einen Spannungsregler (1) aufweist, der eine stabilisierte Versorgungsspannung an die Stromquelle (2), den Verstärker (3) und das Sollwertmodul (6) liefert.

5. Vorrichtung nach einem der vorhergehenden Ansprüche, **dadurch gekennzeichnet, dass** sie eine Sicherheitsschaltung (7) aufweist, die von einem Transistor Q1, einem Widerstand Rlim und einem Potentiometer Plim gebildet ist, wobei der Widerstand Rlim und das Potentiometer Plim als Teilerbrücke an eine stabilisierte Spannung Vreg angeschlossen sind, die den Oszillator (4) speist, wobei der Mittelpunkt der Brücke auf der Basis des Transistors Q1 angeschlossen ist, die Steuerelektrode des Transistors Q1 an den Eingang des Oszillators (4) angeschlossen ist, der die Spannung Vctrl empfängt, und der Kollektor an die stabilisierte Spannung Vreg angeschlossen ist.

6. Vorrichtung nach einem der vorhergehenden Ansprüche, **dadurch gekennzeichnet, dass** der Schalter (5) zwei bipolare Transistoren Q3, Q4 und Widerstände R7, R8, R9, R10 aufweist, wobei die Transistoren derart aufgebaut sind, dass, wenn Q3 durchlässig ist, Q4 durchlässig ist, wobei die Basis von Q4 über den Widerstand R9 an den Kollektor des Transistors Q3 angeschlossen ist, wobei der Widerstand R10 zwischen der Steuerelektrode und der Basis von Q4 verbunden ist, wobei die Steuerelektrode von Q4 direkt an eine Versorgungsspannung Vcc und sein Kollektor an den Heizwiderstand angeschlossen ist, wobei die Steuerelektrode von Q3 an die elektrische Masse und seine Basis an den Mittelpunkt eines Spannungsteilers angeschlossen sind, der aus den Widerständen R7 und R8 besteht, wobei der Widerstand R7 an den Ausgang des Oszillators (4) angeschlossen ist, der die Spannung Vosc abgibt, und der Widerstand R8 an die elektrische Masse angeschlossen ist.

7. Vorrichtung nach einem der vorhergehenden Ansprüche, **dadurch gekennzeichnet, dass** die Stromquelle (2) Folgendes aufweist:

   - einen ausgeglichenen Stromspiegel mit bipolaren Transistoren, der einen kompletten Wilson-Spiegel bildet;
   - einen Widerstand R6;
   - einen Widerstand Rshunt;
   - und einen Widerstand Rbias1;

   wobei die Einheit der vier Transistoren zwei einfache Stromspiegel M1, M2 bildet, die derart kaskadenartig verzweigt und gekreuzt sind, dass die Basisströme der Transistoren dazu neigen, sich aufzuheben, wobei die Steuerelektroden der Transistoren des ersten Spiegels M1 dafür geeignet sind, an eine geregelte Spannung Vreg angeschlossen zu werden, wobei der zweite Spiegel M2 am Ausgang an den Widerstand Rshunt, der an den Widerstand des Thermistors (10) angeschlossen ist, und an den Widerstand Rbias1 angeschlossen ist, der an die elektrische Masse angeschlossen ist, wobei der Widerstand R6 die Steuerelektroden der Transistoren des ersten Spiegels M1 mit ihrer gemeinsamen Basis verbindet.

8. Vorrichtung nach Anspruch 7, **dadurch gekennzeichnet, dass** der Wert des Widerstands R6 im Wesentlichen die Hälfte des Wertes des Widerstands Rbias1 beträgt.

9. Vorrichtung nach einem der vorhergehenden Ansprüche, **dadurch gekennzeichnet, dass** der Verstärker (3) mindestens Folgendes aufweist:

   - ein erstes Differenzpaar DP2 von komplementären bipolaren Transistoren, das eine erste Verstärkungsstufe bildet, welches die Spannung Vtemp auf der Basis eines Transistors und die Spannung Vset auf der Basis des anderen Transistors empfängt;
   - einen Stromspiegel M4, der den Polarisationsstrom von DP2 fixiert;
   - ein zweites Differenzpaar DP1 von komplementären bipolaren Transistoren, das eine zweite Verstärkungsstufe bildet, wobei die Basis eines ersten Transistors des DP1 an den Kollektor eines ersten Transistors des DP2 angeschlossen ist und die Basis des zweiten Transistors des DP1 an den Kollektor des zweiten Transistors des DP2 angeschlossen ist,
   - einen Stromspiegel M3, der den Polarisationsstrom von DP1 fixiert;
   - einen bipolaren Transistor Q2, der die dritte Verstärkungsstufe bildet, wobei die Basis von Q2 an den Kollektor eines Transistors von DP1 angeschlossen ist, wobei der Kollektor von Q2 dafür geeignet ist, an eine geregelte Spannung Vreg angeschlossen zu werden, wobei die Spannung Vctrl am Ausgang der Steuerelektrode von Q2 vorliegt.

10. Vorrichtung nach Anspruch 9, **dadurch gekennzeichnet, dass** der Verstärker Widerstände R1, R2, R3, R4, R5 und Widerstände Rbias2, Rbias3 aufweist, wobei die Steuerelektroden der Stromspiegeltransistoren M3 dafür geeignet sind, an die geregelte Spannung Vreg angeschlossen zu werden, wobei der Kollektor eines Spiegeltransistors M3 an den Widerstand Rbias2 angeschlossen ist und der Kollektor des anderen Spiegeltransistors M3 an die Steuerelektroden der Transistoren des ersten Differenzpaares DP1 angeschlossen ist, wobei die Kollektoren des Spiegels M3 über die Widerstände R3 und R4 an die Masse angeschlossen sind, wobei die Steuerelektroden des Spiegels M4 an die Masse angeschlossen sind, wobei ein Kollektor des Spiegels M4 dafür geeignet ist, über den Widerstand Rbias3 an die geregelte Spannung Vreg angeschlossen zu werden, und der andere Kollektor an die Steuerelektroden des Differenzpaares DP2 angeschlossen ist, wobei die Kollektoren von DP2 über den Widerstand R1 zum einen und über den Widerstand R2 zum anderen an die geregelte Spannung Vreg angeschlossen sind, wobei der Kollektor des Transistors Q2 dafür geeignet ist, an die geregelte Spannung Vreg angeschlossen zu werden, wobei die Steuerelektrode von Q2 über den Widerstand R5 an die Masse angeschlossen ist.

11. Vorrichtung nach einem der vorhergehenden Ansprüche, **dadurch gekennzeichnet, dass** der Oszillator (4) bipolare Transistoren Q5, Q6, Q7, Q8, Widerstände R11, R12, R13, R14, R15, R16, R17, R18, R19, R20, R21 und einen Kondensator C1 umfasst, die dafür aufgebaut sind, einen Kippgenerator zu bilden, wobei die freie Pendelfrequenz durch den Widerstand R12 bestimmt wird, der zwischen dem Kondensator C1 und der Steuerelektrode von Q8 verbunden ist, die den Ausgang des Oszillators bildet;

- wobei der Ladestrom des Kondensators C1 gesteuert wird, um das Taktverhältnis der Spannung Vosc, die am Ausgang des Oszillators abgegeben wird, zu modulieren, wobei der Ladestrom durch die Spannung Vctrl über den Widerstand R11 geliefert wird;
- wobei der Oszillator elektrisch durch eine geregelte Spannung Vreg gespeist wird, an die die Widerstände R13, R14, R15 angeschlossen sind, die jeweils an den Kollektor von Q5, Q6 und Q7 und den Kollektor des Transistor Q8 angeschlossen sind;
- wobei die Transistoren Q5 und Q6 und die Widerstände R13, R14, R16, R17 und R19 einen Ein-Aus-Schalter nach Art des Schmitt-Triggers bilden, wobei das Signal an den Anschlussklemmen des Kondensators C1 auf der Basis des Transistors Q5 gesendet wird, der den Eingang des Ein-Aus-Schalters bildet;
- wobei die Ausgabe des Ein-Aus-Schalters, der von dem Kollektor von Q6 gebildet ist, an einen von dem Transistor Q7 und den Widerständen R15, R18 und R20 gebildeten Inverter gesendet wird, wobei R18 zwischen der Basis von Q7 und dem Kollektor von Q6 verbunden ist und R20 zwischen der Basis und der elektrischen Masse verbunden ist;
- wobei das invertierte Signal an dem Kollektor des Transistors Q7 abgegriffen und auf einer Impedanzanpassungsstufe, die aus dem Transistor Q8 besteht und nachgeschaltet ist, gesendet wird, und der Widerstand R21 als gemeinsamer Kollektoraufbau konfiguriert ist.

12. Vorrichtung nach einem der vorhergehenden Ansprüche, **dadurch gekennzeichnet, dass** sie einen Ausgang aufweist, der ein Signal Vtout liefert, das die Spannung an den Anschlussklemmen des Thermistors (10) kopiert..

## Claims

1. A device for regenerating electronic components exposed to ionising radiation using heat, having:

   - a heating resistor (20) intended for heating a component to be regenerated; and
   - a current source (2);

   said device being **characterised in that** it further has at least the following components:

   - a thermistor (10) connected to said current source (2), thermally coupled to said heating resistor, said thermistor, through which said current flows, having a voltage Vtemp across its terminals which voltage reflects the temperature of said heating resistor (20);
   - an error amplifier (3), which amplifies the difference between a setpoint voltage Vset and the voltage Vtemp, delivering a voltage Vctrl that corresponds to said amplified difference;
   - a switch (5), which switches the current flowing through said heating resistor (20); and
   - an oscillator (4), which delivers a voltage Vosc formed with a modulated duty cycle, the duty cycle of the pulses of said voltage Vosc being a function of the voltage Vctrl, said pulses controlling the opening of said switch (5).

2. The device according to claim 1, **characterised in that** it has a setpoint module (6) that delivers an adjustable voltage Vset, which reflects the heating setpoint temperature selected for said heating resistor (20).

3. The device according to either one of the preceding claims, **characterised in that** said components are embodied as discrete electronic components.

4. The device according to any of the preceding claims, **characterised in that** it has a voltage regulator (1) supplying a stabilised supply voltage to said current source (2), said amplifier (3) and said setpoint module (6).

5. The device according to any one of the preceding claims, **characterised in that** it has a safety circuit (7) formed by a transistor Q1, a resistor Rlim and a potentiometer Plim, the resistor Rlim and the potentiometer Plim being connected in the form of a divider bridge to a stabilised voltage Vreg powering said oscillator (4), the center tap of said bridge being connected to the base of the transistor Q1, the emitter of the transistor Q1 being connected to the input of said oscillator (4) that receives the voltage Vctrl, and the collector being connected to said stabilised voltage Vreg.

6. The device according to any one of the preceding claims, **characterised in that** said switch (5) has two bipolar transistors Q3, Q4 and resistors R7, R8, R9, R10, said transistors being put together such that when Q3 is on, Q4 is on, the base of Q4 being connected to the collector of the transistor Q3 via the resistor R9, the resistor R10 being connected between the emitter and the base of Q4, the emitter of Q4 being directly connected to a supply voltage Vcc, and the collector thereof being directly connected to said heating resistor, the emitter of Q3 being connected to electrical ground, and the base thereof being connected to the center tap of a voltage divider consisting of the resistors R7 and R8, the resistor R7 being connected to the output of said oscillator (4) that delivers the voltage Vosc, and the resistor R8 being connected to electrical ground.

7. The device according to any one of the preceding claims, **characterised in that** said current source (2) has:

   - a balanced current mirror with four bipolar transistors, forming a full Wilson mirror;
   - a resistor R6;
   - a resistor Rshunt;
   - and a resistor Rbias1;

   the four transistors together forming two simple current mirrors M1, M2 that are cascaded and cross-coupled such that the base currents of the transistors tend to cancel each other out, the emitters of the transistors of the first mirror M1 being able to be connected to a regulated voltage Vreg, the output of the second mirror M2 being connected to the resistor Rshunt, which is connected to the resistor of said thermistor (10), and to the resistor Rbias1, which is connected to electrical ground, the resistor R6 connecting the emitters of the transistors of the first mirror M1 to their common base.

8. The device according to claim 7, **characterised in that** the resistance value of the resistor R6 is approximately half the resistance value of the resistor Rbias1.

9. The device according to any one of the preceding claims, **characterised in that** said amplifier (3) has at least:

   - a first differential pair DP2 with complementary bipolar transistors, which forms a first amplification stage, which receives the voltage Vtemp at the base of one transistor and the voltage Vset at the base of the other transistor;
   - a current mirror M4, which fixes the bias current of DP2;
   - a second differential pair DP1 with complementary bipolar transistors, which forms a second amplification stage, the base of a first transistor of DP1 being connected to the collector of a first transistor of DP2, and the base of the second transistor of DP1 being connected to the collector of the second transistor of DP2;
   - a current mirror M3, which fixes the bias current of DP1;
   - a bipolar transistor Q2, which forms the third amplification stage, the base of Q2 being connected to the collector of one transistor of DP1, the collector of Q2 being able to be connected to a regulated voltage Vreg, the voltage Vctrl being present at the output of the emitter of Q2.

10. The device according to claim 9, **characterised in that** said amplifier has resistors R1, R2, R3, R4, R5 and resistors Rbias2, Rbias3, the emitters of the transistors of the current mirror M3 being able to be connected to the regulated voltage Vreg, the collector of one transistor of the mirror M3 being connected to the resistor Rbias2, and the collector of the other transistor of the mirror M3 being connected to the emitters of the transistors of the first differential pair DP1, the collectors of the mirror M3 being connected to ground via the resistors R3 and R4, the emitters of the mirror M4 being connected to ground, one collector of said mirror M4 being able to be connected to the regulated voltage Vreg via the resistor Rbias3, and the other collector being connected to the emitters of the differential pair DP2, the collectors of DP2 being connected to the regulated voltage Vreg, one via the resistor R1 and the other via the resistor R2, the collector of the transistor Q2 being able to be connected to the regulated voltage Vreg, the emitter of Q2 being connected to ground via the resistor R5.

11. The device according to any one of the preceding claims, **characterised in that** said oscillator (4) comprises bipolar transistors Q5, Q6, Q7, Q8, resistors R11, R12, R13, R14, R15, R16, R17, R18, R19, R20, R21 and a capacitor C1, which are put together to form a relaxation oscillator, the free-running oscillation frequency being determined by the resistor R12 connected between said capacitor C1 and the emitter of Q8, which forms the output of said oscillator;

   - the charging current of the capacitor C1 being controlled so as to modulate the duty cycle of the voltage Vosc delivered at the output of said oscillator, said charging current being supplied by the voltage Vctrl via the resistor R11;
   - said oscillator being powered by a regulated voltage Vreg to which are connected the resistors R13, R14, R15, which are connected to the collector of Q5, Q6 and Q7, respectively, and the collector of the transistor Q8;
   - the transistors Q5 and Q6 and the resistors R13, R14, R16, R17 and R19 forming a Schmitt trigger-type flip-flop, the signal across the terminals of said capacitor C1 being sent to the base of the transistor Q5 that constitutes the input of said flip-flop;
   - the output of said flip-flop, formed by the collector of Q6, being sent to an inverter formed by the transistor Q7 and the resistors R15, R18 and R20, R18 being connected between the base of Q7 and the collector of Q6, and R20 being connected between said base and electrical ground;
   - the inverted signal being taken from the collector of the transistor Q7 and being sent to an impedance-matching stage consisting of the transistor Q8, connected up as a follower, and the resistor R21, which are configured in common-collector arrangement.

12. The device according to any one of the preceding claims, **characterised in that** it has an output that supplies a signal VTout that copies the voltage across the terminals of said thermistor (10).

FIG.1

EP 3 653 019 B1

FIG.2

FIG.3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3034947 A1